# EUROPEAN PATENT APPLICATION

(11) **EP 2 060 656 A2**
(43) Date of publication of application: **20.05.2009**
(21) Application number: 09003143.6
(22) Date of filing: 24.04.2007
(51) Int. Cl.: C23C 14/06

(54) **Hard carbon film and hard carbon film sliding member**

(30) Priority: 24.04.2006 JP 2006119116; 24.04.2006 JP 2006119098
(62) Divisional of application: 07008327.4
(71) Applicant: Nissan Motor Co., Ltd., Kanagawa 221-0023 (JP)
(72) Inventor: Okamoto, Yusuke, Atsugi-shi Kanagawa 243-0192 (JP); Yasuda, Yoshiteru, Atsugi-shi Kanagawa 243-0192 (JP); Yamauchi, Takeshi, Atsugi-shi Kanagawa 243-0192 (JP)
(74) Representative: Schaeberle, Steffen

(57) **Abstract**

Provided is a hard carbon film, which is to be used in a sliding member, more specifically, at a sliding site thereof in contact with a counter member. The hard carbon film contains at least one of cobalt and nickel in a total content within the range of more than 1.4 to less than 39 atom% and contains cobalt and nickel aggregates having a diameter of beyond 5 nm within a predetermined ratio or less. In this way, the hard carbon film reduced in friction coefficient than ever, manufactured in a simple process, and effectively working in a wide variety of lubricating oils can be provided.

## Description

### BACKGROUND OF THE INVENTION

### 1. Field of the Invention

The present invention relates to a hard carbon film excellent inlowfrictioncoefficient, and, more particularly to a low-friction hard carbon film suitable for use in lubricating oil such as engine oil and transmission oil.

### 2. Description of the Related Art

The hard carbon film is a film formed of amorphous carbon or carbon hydride and also called as a-C:H (amorphous carbon or hydrogenated amorphous carbon), i-C (i-carbon) and DLC (diamond like carbon). Such a hard carbon film can be formed by a gas-phase synthetic method such as a plasma CVD (Chemical Vapor Deposition) method or an ion-beam deposition method. In the plasma CVD method, a hard carbon film is formed by decomposing a hydrocarbon gas by plasma, and in the ion-beam deposition method, a hard carbon film is formed using carbon or hydrocarbon ions. The hard carbon film formed in this way is very hard, and has a smooth surface and excellent anti-abrasion properties. In addition, by virtue of the solid lubrication properties of the hard carbon film, the friction coefficient of the film is low, imparting excellent sliding properties to the film. To explain more specifically, the friction coefficient of the smooth surface of a general steel material in the absence of lubricating oil is 0.5 to 1.0, whereas that of the hard carbon film in the same conditions is about 0.1.

Taking advantage of such excellent properties, the hard carbon film has been used in processing tools such as cutting tools (e. g. , drill blade and polishing/grinding tools) , molds for plastic working, and sliding parts used in the absence of lubricating oil (e.g., a valve cock and a capstan roller). On the other hand, in machinery parts used in an internal combustion engine and slidably moving in lubricating oil, it has been desired to reduce mechanical loss as much as possible, in view of energy consumption and environmental concerns. To satisfy these demands, the application of a hard carbon film to a site exposed to stringent conditions and having large friction loss has been studied. More specifically, several attempts have been made to reduce a friction coefficient not only in the absence of lubricating oil but also in the presence of lubricating oil by applying a hard carbon film to a sliding member and also controlling the composition of the hard carbon film and the surface state thereof.

For example, Japanese Patent Application Laid-open No. 2003-247060 (hereinafter, "Patent Document 1") discloses a method of adding at least one type of element selecting from the group consisting of elements of the IVa, Va and Via families and Si to such a hard carbon film. By this method, the friction coefficient of the hard carbon film is reduced compared to the film containing none of these elements. Japanese Patent Application Laid-open No. 2004-099963 (hereinafter, "Patent Document 2") discloses a method of providing an Ag cluster to such a hard carbon film. Besides this, Japanese Patent Application Laid-open No. 2004-115826 (hereinafter, "Patent Document 3") discloses a technique for reducing a friction coefficient by adding an appropriate metal element to such a hard carbon film and further controlling the content of oxygen in the film. There is another technical issue in which, when such a sliding member is used, it is naturally demanded that the friction of the counterpart material should be reduced. To satisfy this demand, in a method disclosed in Japanese Patent Application Laid-open No. 2003-027214 (hereinafter, "Patent Document 4"), a surface layer of a sliding member is formed of a relatively soft hydrogen-containing carbon film and any one of elements of V, Cr, Zr, Nb, Ta, Mo, W, Pd, Pt, Ti, Al, Pb and Si is added to the hydrogen-containing carbon film in order to reduce friction.

### SUMMARY OF THE INVENTION

However, in the Patent Document 1, the friction coefficient, which is measured in a motoring test (although the friction coefficient may differ depending on the measurement method), is 0.06. Further reduction in friction coefficient is desired. In the Patent Document 2, the friction coefficient value is 0.04 at a minimum. Since the friction coefficient is measured in a reciprocation movement test herein, the friction coefficient value cannot be simply compared to others. However, further reduction in friction coefficient is also desired. The Patent Document 2 has another problem such that since an Ag cluster must be provided on the hard carbon film while controlling the size and number thereof, the controlling of the process is complicated.

In the Patent Document 3, not only the content of a metal element but also the content of oxygen must be controlled. A further simpler process is therefore desired. The Patent Document 3 has another issue in which, since an extreme-pressure additive such as a molybdenum dithiocarbamate (MoDTC) must be added to lubricating oil, the hard carbon film is used only in limited types of lubricating oils. In the Patent Document 4 havingmeans for suppressing abrasion of a counterpart member, the friction coefficient of a carbon film containing hydrogen in lubricating oil is generally higher than a carbon film substantially containing no hydrogen (for example, see Japanese Patent Application Laid-open No. 2000-297373). Even if a specific metal element is added to overcome the disadvantage in friction coefficient of the hydrogen-containing carbon film, the friction coefficient reducing effect maybe limited to a certain level.

The present invention has been achieved to solve the problems mentioned above, and an object of the invention is to provide a hard carbon film further reduced in friction coefficient, manufactured in a simple process and effectivelyused in wide variety types of lubricating oils. A hard carbon film of the present invention substantially containing no hydrogen is also directed to suppressing friction of a counterpart member.

The present inventors have conducted intensive studies with a view to attaining the aforementioned objects. The present inventors have studied types of hard carbon films and film forming methods, and further, a doping method for a metal element into a hard carbon film as an additive component. As a result, they have found that doping of cobalt and nickel has a good effect upon low abrasion properties and abrasion resistance properties of a counterpart material. They have further studied on an appropriate addition amount of the dopant for eliciting these properties as much as possible and a composition of the hard carbon film, and the present invention has been achieved based on these studies.

More specifically, the present invention has been attained based on the aforementioned findings and directed to a hard carbon film that is characterized by containing at least one of cobalt (Co) and nickel (Ni) in a total amount of more than 1.4 atom% to less than 39 atom%. The film can be suitably used in lubricating oil for automobile engine oil and transmission oil.

As a result of the intensive studies, the present inventors have elucidated that suppression of metal aggregate generation in the film is beneficial in eliciting more excellent friction coefficient reduction effect. The aggregates have a size distribution from large to small. Among them, they have found that those having a diameter beyond 5 nm have an effect upon friction coefficient. In other words, those are to be suppressed in generation. The present invention has been achieved based on the elucidation.

As a result of the intensive studies, the present inventors have further elucidated that a friction coefficient can be reduced by forming a hard carbon film by stacking layers having a relatively high cobalt/nickel content and layers having relatively low cobalt/nickel content, one on top of another, and optimizing the conditions of the laminate. They have also elucidated that the effect of the hard carbon film can be remarkably exerted when the film is used in lubricating oil such as automobile engine oil and transmission oil. The present invention has been achieved based on these elucidations.

### BRIEF DESCRIPTION OF THE DRAWINGS

Exemplary embodiments of the invention will become more fully apparent from the following description and appended claims, taken in conjunction with the accompanying drawings. Understanding that these drawings depict only exemplary embodiments and are, therefore, not to be considered limiting of the invention' s scope, the exemplary embodiments of the invention will be described with additional specificity and detail through use of the accompanying drawings in which:
Fig. 1 is a schematic view of a state of cutting a sample to be subjected to observation of an aggregate by an FIB method;
Fig. 2 is a schematic view of a typical structure of a film observed by a transmission electron microscope;
Fig. 3 shows a method of measuring a size of an aggregate when a dumbbell-form aggregate is observed;
Fig. 4 shows evaluations results of Examples 1 to 5;
Fig. 5 shows evaluations results of Examples 6 to 10;
Fig. 6 shows evaluations results of Comparative Examples 1 to 3;
Fig. 7 is a schematic view showing a vacuum vessel of a film forming apparatus; and
Fig. 8 is a schematic view showing a stripe of dark and light strains under TEM observation.

### DETAILED DESCRIPTION OF THE PREFERRED MMBODIMENTS

### First embodiment

A hard carbon film according to a first embodiment contains cobalt and/or nickel in a total amount of more than 1.4 atom% to less than 39 atom%. The hard carbon film, since it contains cobalt and/or nickel, shows a low friction coefficient and reduces the friction of a counterpart material. The reason is presently considered that the ability of the surface of the hard carbon film to absorb a main component (base oil component) and additive components contained in a lubricant is improved by addition of cobalt and/or nickel to the film, with the result that the base oil component and the additive components form a thin film on the surface of the hard carbon film. The film formed in this way can prevent direct contact of the hard carbon film with a counterpart material even in so-called boundary lubrication conditions where a surface pressure is high and a sliding rate is low. As a consequence, the friction coefficient is conceivably reduced. In this case, it is not always necessary to contain cobalt and nickel entirely from the surface of the hard carbon film to a deeper portion. It is sufficient to contain them at least from the sliding surface to the part to be worn out by sliding. Furthermore, the hard carbon film can be modified by providing a layer containing no cobalt and nickel as a sacrificial layer in consideration of adaptation of a material at the beginning.

When the total amount of cobalt and nickel is less than 1.4 atom%, the aforementioned adsorption effect is not sufficiently exerted. To sufficiently obtain the adsorption effect, it is better to add cobalt and/or nickel preferably in an amount of 3 atom% or more, and more preferably, 6 atom%. On the other hand, when the total amount of cobalt and nickel exceeds 39 atom%, it is speculated that the network structure of carbon atoms is disturbed by the presence of cobalt and nickel atom. As a result, a low abrasion performance and hardness that a hard carbon film inherently has will be spoiled. For the reason, the addition amount is less than 39 atom%, preferably less than 20 atom%, and more preferably, less than 16 atom%.

To explain the mechanism for lowering friction more specifically, assumingly, cobalt and nickel added to a film may not directly contribute to lowering friction but contribute to exerting a quantum mechanical effect upon surrounding carbon atoms, thereby improving the performance of carbon atoms for adsorbing additives. Therefore, it is desirable to increase chances of cobalt and nickel atoms in neighboring with carbon atoms consisting of the main phase of the film as much as possible. In other words, cobalt and nickel are desirably dispersed uniformly in the matrix as small a cluster as possible, ultimately in a state of a single atom. Conversely, it is not preferable that cobalt and nickel added to the film are present as aggregates, because their chances of neighboring with carbon atoms decrease, and the addition effect reduces. In addition, when cobalt and/or nickel are present as aggregates, it was observed that the carbons around them was, present not in an amorphous state but in a graphite state in most cases. In the hard carbon film for use in reducing friction, it is generally not preferable to increase the content of a graphite component. In view of this, it is desirable to suppress the generation of aggregates.

Based on various experiments, the present inventors have found that the minimum size of aggregates influencing a friction coefficient is 5 nm in diameter. As mentioned above, the amount of aggregates is preferably reduced as much as possible. Of the aggregates, particularly, those having a diameter of 5 nm or more are desired to reduce. The ratio of the aggregates of 5 nm or more in diameter is set at less than 40 area%, and preferably, less than 12 area%, which is quantified by the method shown in Examples later. Of course, the smaller the amount of aggregates, the better.

When the addition amount of cobalt and/or nickel in the film is originally small, even if the ratio of aggregates is suppressed so as to fall within the range mentioned above, the ratios of cobalt atoms and nickel atoms to be uniformly dispersed in the matrix greatly reduce, decreasing the friction reducing effect. Therefore, it is preferable that the ratio of aggregates is suppressed to fall within a predetermined ratio based on the total amount of cobalt and nickel added. Assuming that the ratio of aggregates is represented by X area% and the total amount of cobalt and nickel is represented by Y area%, the ratio of aggregates is desirably controlled so as to satisfy the relationship of X<4Y.

The generation of aggregates can be suppressed by reducing a growth rate and reducing the bias voltage applied to the substrate during a film-deposition process and maintaining the temperature of the substrate low. Although a suppression method is not limited to these and other appropriate methods can be employed. In view of inhibiting generation of aggregate, a sputtering method is advantageous over an arc-ion plating method in depositing a film. However, aggregates are generated even by the sputtering method depending on the conditions. Needless to say, the process conditions must be set appropriately.

The hard carbon film of the present invention can be used in a dry condition. However, as explained above, since friction coefficient is reduced principally by adsorption of the main component (base oil component) of the lubricant and additives to the hard carbon film, the effect of reducing friction coefficient can be more efficiently produced when the hard carbon film is used in a lubricant. Therefore, the hard carbon film is preferably used in a lubricant.

The lubricant used in this case can contain an additive. More specifically, the molecules of the additive preferably have an intramolecular hydroxyl group. Whether an additive molecule is easily adsorbed onto the surface of the hard carbon film depends on a functional group present in the molecule. A hydroxyl group can be mentioned as a preferable functional group. The larger the number of hydroxyl groups present in the molecule of an additive, the more strongly the additive can be adsorbed to the hard carbon film. Therefore, the larger the number of functional groups present in the molecule of an additive, the more advantageous in reducing a friction coefficient. However, in the case where the number of hydroxyl groups is too large, the hard carbon film may be sometimes separated from base oil components in some cases. Thus, an additive canbe appropriately selected depending on the use conditions (mainly temperature) of parts.

As a lubricant, automobile engine oil can be used. In particular, automobile engine oil containing an additive having an intramolecular hydroxyl group is preferable as a lubricant. In this case, as an example of the additive, a fatty acid monoglyceride can be mentioned. However, the additive is not limited to this, of course. Furthermore, to obtain a low friction coefficient in such a lubricant, it is preferable that the content of hydrogen atoms in a film is reduced. More specifically, the content of hydrogen atoms is desirably less than 6 atom% and further desirably less than 1 atom%. This is because the smaller the hydrogen content, the easier the additive adsorbs.

Note that the hard carbon film low in hydrogen content can be obtained by a physical vapor deposition (PVD) method such as a sputtering method or an ion plating method, which does not use hydrogen and a hydrogen containing compound, substantially. A hydrocarbon gas can be added to an atmospheric gas in the sputtering method. However, the addition of a hydrocarbon gas is not desirable in the present invention. When a film is formed by a PVD method in an atmosphere containing no hydrocarbon gas using a hydrocarbon-free carbon source such as graphite, the hydrogen content within a film can be suppressed to less than 1 atom%.

Examples of the present embodiment, as well as Comparative Examples, will be explained below.

### (Example 1)

A disk-form substrate formed of cement steel (Japanese Industry Standard, SCM 415) and having of 30 mm diameter and 3 mm thick was prepared. The surface of the substrate was lapped so as to have a surface roughness (Ra) of 0.020 µm, and coated with a hard carbon film by a magnetron sputtering (MS) method. As a sputtering target, a graphite disk of 80 mm radius was used. A metal cobalt plate was placed on the graphite (carbon) target. By virtue of this arrangement, when the carbon target was sputtered, the hard carbon film was allowed to contain a predetermined amount of cobalt, simultaneously. The cobalt plate was formed into a fan shape having a radius of 80 mm and an apex angle of 7.5° such that the cobalt plate occupies 1/48 of the entire target. As an atmospheric gas during sputtering, argon was used. When a film was formed, a bias voltage to be applied to the substrate was set at of 40 V and an excitation power for exciting plasma was set at 200 W. Processing time was calculated from a film-forming rate previously obtained in a preliminary test. The preliminary test was performed in the same conditions as above except that the carbon target alone was used and the cobalt plate was not used. As a result of the preliminary test, a film-forming rate was obtained as 0.31 µm/hour. Based on the film-forming rate, a film-forming process was performed for 3 hours. A surface roughness (Ra) was measured after completion of the film-deposition process, and it was 0.022.

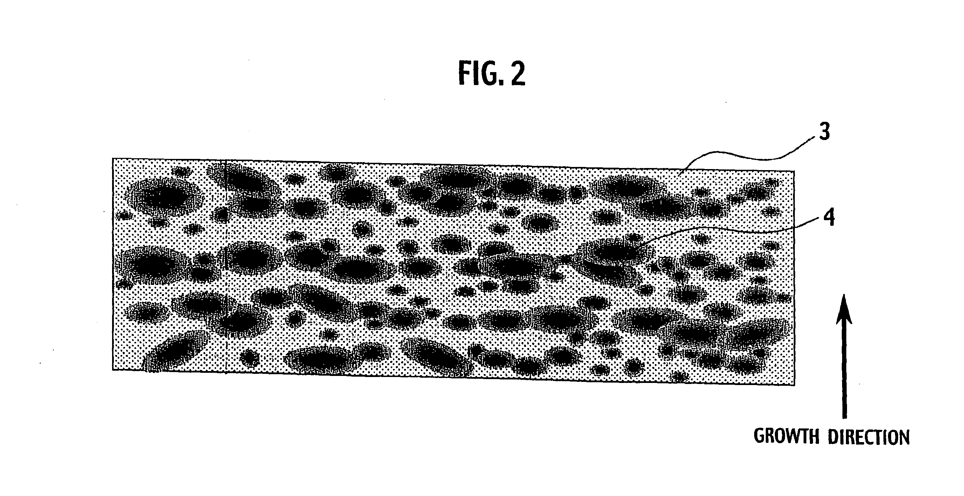

Subsequently, the hard carbon film thus obtained was analyzed for elements of the film. Cobalt content was analyzed by X-ray photoelectron spectroscopy (XPS). While the surface was etched with argon gas, the depth profile of cobalt was determined. The concentration of cobalt was measured at three points having distances of 5 nm, 10 nm and 15 nm from the surface of a sample of the hard carbon film. The average of the measured values was used as an average content of cobalt. As a result of measurement, the content of cobalt was 14 atom%. Furthermore, the sample was evaluated for aggregates under observation by a transmission electron microscope When the size of aggregates is sufficiently large, they can be observed by a scanning electron microscope; however, when the size of aggregates is in the order of 5 nm, a transmission electro microscope must be used. In the analysis of this example, a high-resolution transmission electron microscope was used at an acceleration voltage of 300 kV. Since a metal element (such as cobalt or nickel) added to the hard carbon film has a high density, it gives a dark image. In contrast, since amorphous carbon of a matrix has a low density, it gives a whitish image. Therefore, both elements can be easily distinguished by images observed by the transmission electron microscope. Fig. 2 shows a schematic image observed by the transmission electron microscope.

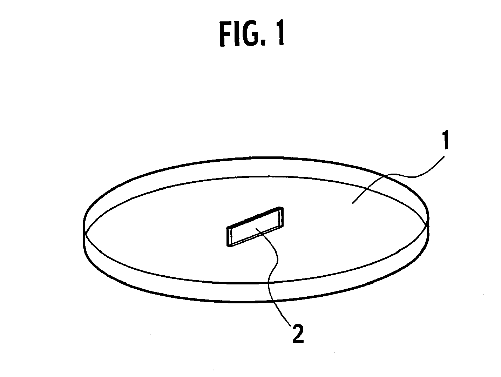

A metal aggregate in a sample is principally captured by a transmission electron microscope as a transmission image. Accordingly, the area ratio occupied by metal aggregates in a transmission electron micrograph does not match the volume ratio of the metal aggregates in a film. The essential feature of the present invention resides in that the volume ratio of metal aggregates is suppressed within a predetermined range; however, it is generally difficult to determine the ratio of aggregates present in the film. Accordingly, in the present invention, the ratio of aggregates present in a film is represented by an area ratio of the dark portions ascribed to transmission images of metal aggregates in an electron transmissionmicrographic image. Of course in this case, the thicker the sample film, the lager the amount of metal aggregates observed in the transmission image. Therefore, samples must be prepared so as to have the same thickness and then subj ected to quantification. In the analysis of the present invention, as shown in Fig. 1, a sample was cut out perpendicularly to the substrate (parallel to the growth direction) in a thickness of 100 nm by the focused ion beam (FIB) method. Metal aggregates were always analyzed by observation with respect to a sample having a thickness of 100 nm. The magnification was set at 2 million times.

Furthermore, when the field of vision is small, analysis is affected by statistical variations. Therefore, the analysis of the present invention was performed by taking a photograph of an area of 250 nm x 250 nm. Aggregates as well as metal aggregates are prone to minimize their surface energy. When the surface energy is isotropic, aggregate forms a sphere and the projection image thereof or a transmission image results in a circle. However, actually, the shapes of aggregates are not a sphere and naturally the trajection image is not a complete circle. In this case, there is an issue of how to evaluate the size of the aggregate. Therefore, the analysis of the present invention employs a concept of an "equivalent circle diameter", which is defined as the diameter of a circle having the same area S as that (S) of a second-dimensional figure enclosed by a single line. More specifically, the equivalent circle diameter can be obtained by dividing the area S by the circular constant π, and obtaining the square root of the quotient and multiplying the square root by2. As described above, it is important to suppress the aggregates having an equivalent circle diameter beyond 5 nm.

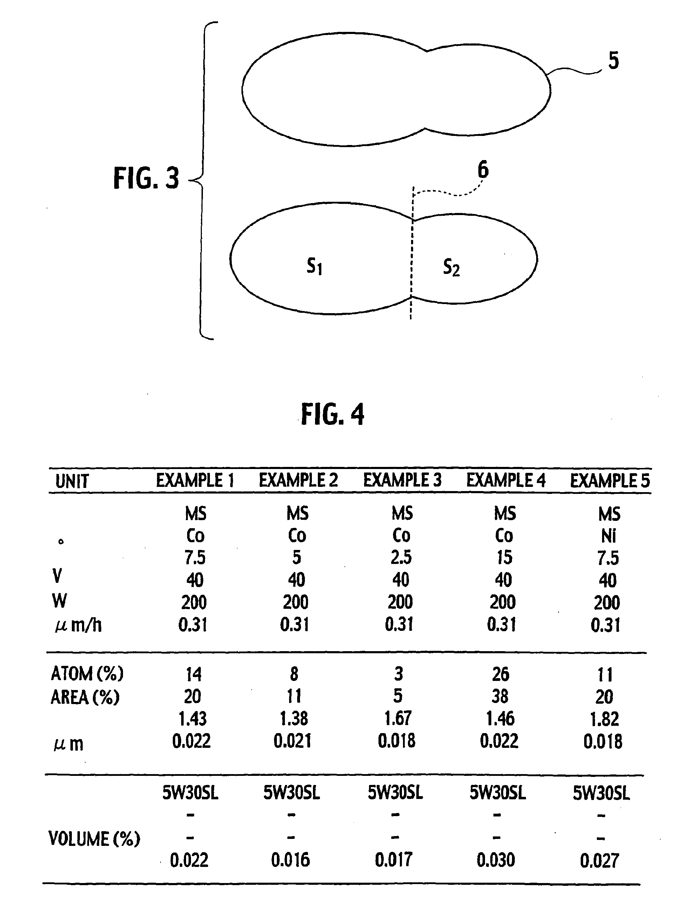

The analysis of the present invention is performed based on the observation by a transmission electron microscope, there are some cases where not less than 2 aggregates are overlapped. When substantially-round two or more particles are overlapped in part, a dumbbell-shaped transmission image is resulted as shown in Fig. 3. In this case, the dumbbell shaped image is divided by a straight line into two regions at the constricted portion (indicated by reference symbols S1 and S2 in the drawing) and the equivalent circle diameter of each of the regions is determined. The equivalent circle diameter obtained in calculation is smaller than the actual diameter of each of the aggregates, by just the overlap. Taking such a fact into consideration, "an equivalent circle diameter of 5 nm" is used as a reference. The amount of aggregates present in a film was checked, and it was 20%.

Next, the evaluation method for friction properties will be described. The friction properties of the sample were evaluated by a ball-on-disk method. In testing the friction properties, automobile engine oil 5W-30SL was used as a lubricant. While the sample was rotated in the engine oil, a ball of 4 mm diameter formed of bearing steel (Japanese Industrial Standard SUJ2) was pressed against the sample and torque applied to an arm holding the ball was measured to obtain a friction coefficient. The diameter of a sliding mark was set at 10 mm. The temperature of the engine oil was set at 80°C. The load vertically applied onto the ball was 6 N. Note that the ball was fixed so as not to roll by sliding. A sliding rate was set at 3 cmper second. The friction coefficient was calculatedinconsiderationof the running-ineffect. Therefore, a measurement value obtained 5 minutes after initiation of the test was regarded as the friction coefficient of the material. The friction coefficient of the hard carbon film of this example was 0.022.

### (Example 2)

The surface of the same substrate as in the Example 1 was coated with a hard carbon film by magnetron sputtering using a carbon target in the same manner as in the Example 1.

As the sputtering target, a fan-shaped metal cobalt plate having a radius of 80 mm and an apex angle of 5° was placed on a disk-form carbon target of 80 mm in radius. As a growth rate, the value estimated in the Example 1 was used as it was. A film-deposition process was performed for 3 hours in total. A substrate bias voltage was set at 40 V and a plasma excitation power was set at 200 W. The surf ace roughness (Ra) of the sample was measured af ter completion of the process, and it was 0.021 µm. When the film was analyzed in the same manner as in the Example 1, the content of cobalt was 8 atom%, the content of aggregates was 11 area%, and the friction coefficient was 0.016.

### (Example 3)

The surface of the same substrate as in the Example 1 was coated with a hard carbon film by magnetron sputtering using a carbon target in the same manner as in the Example 1. As the sputtering target, a fan-shaped metal cobalt plate having a radius of 80 mm and an apex angle of 2.5° was placed on a disk-form carbon target of 80 mm in radius. As a growth rate, the value estimated in the Example 1 was used as it was. A film-forming process was performed for 3 hours in total. A substrate bias voltage was set at 40 V and a plasma excitation power was set at 200 W. The surface roughness (Ra) of the sample was measured after completion of the process, and it was 0.018 µm. When the film was analyzed in the same manner as in the Example 1, the content of cobalt was 3 atom%, the content of aggregates was 5 area%, and the friction coefficient was 0.017.

### (Example 4)

The surface of the same substrate as in the Example 1 was coated with a hard carbon film by magnetron sputtering using a carbon target in the same manner as in the Example 1. As the sputtering target, a fan-shaped metal cobalt plate having a radius of 80 mm and an apex angle of 15° was placed on a disk-form carbon target of 80 mm in radius. As a growth rate, the value estimated in the Example 1 was used as it was. A film-forming process was performed for 3 hours in total. A substrate bias voltage was set at 40 V and a plasma excitation power was set at 200 W. The surface roughness (Ra) of the sample was measured after completion of the process, and it was 0.014 µm. When the film was analyzed in the same manner as in the Example 1, the content of cobalt was 26 atoms%, the content of aggregates was 38 area%, and the friction coefficient was 0.030.

### (Example 5)

The surface of the same substrate as in the Example 1 was coated with a hard carbon film by magnetron sputtering using a carbon target in the same manner as in the Example 1. As the sputtering target, a fan-shaped metal cobalt plate having a radius of 80 mm and an apex angle of 7.5° was placed on a disk-form carbon target of 80 mm in radius. As a growth rate, the value estimated in the Example 1 was used as it was. A film-forming process was performed for 3 hours in total. A substrate bias voltage was set at 40 V and a plasma excitation power was set at 200 W. The surface roughness (Ra) of the sample was measured after completion of the process, and it was 0. 018 µm. When the film was analyzed in the same manner as in the Example 1, the content of cobalt was 11 atoms%, the content of aggregates was 20 area%, and the friction coefficient was 0. 027.

### (Example 6)

The surface of the same substrate as in the Example 1 was coated with a hard carbon film by magnetron sputtering using a carbon target in the same manner as in the Example 1. As the sputtering target, a fan-shaped metal nickel plate having a radius of 80 mm and an apex angle of 2.5° was placed on a disk-form carbon target of 80 mm in radius. Note that the bias voltage to be applied to the substrate was raised to 100 V. The film growth rate was estimated as 0.38 µm per hour based on a preliminary experiment performed in the same manner as in the Example 1 except that no nickel plate was used. A film-forming process was performed for 3 hours in total. The plasma excitation power was set at 200 W. The surface roughness (Ra) of the sample was measured after completion of the process, and it was 0.017 µm. When the film was analyzed in the same manner as in the Example 1, the content of nickel was 2 atom%, the content of aggregates was 9 area%, and the friction coefficient was 0.029.

### (Example 7)

A sample prepared in the same batch as in the Example 1 was evaluated in a different type of lubricating oil. The contents of cobalt and aggregates and surface roughness were regarded as the same as in the Example 1 (measurement was not specifically performed). The lubricating oil was prepared by adding glycerin monooleate (GMO) to poly α-olefin (PAO) in an amount of 1% by volume in terms of outer percentage, and thoroughly stirred to put in use. The conditions of the friction test other than those mentioned above were the same as in the Example 1. The friction coefficient was 0.011.

### (Example 8)

Subsequent to the Example 7, a sample prepared in the same batch as in the Example 1 was evaluated in a different type of lubricating oil. The contents of cobalt and aggregates and surface roughness were regarded as the same as in the Example 1 (measurement was not specifically performed). The lubricating oil was prepared by adding glycerin monooleate (GMO) to engine oil 5W30SL in an amount of 1% by volume in terms of outer percentage, and thoroughly stirred to put in use. The conditions of the friction test other than those mentioned above were the same as in the Example 1. The friction coefficient was 0.014.

### (Example 9)

Subsequent to the Example 7 and Example 8, a sample prepared in the same batch as in the Example 1 was evaluated in a different type of lubricating oil. The contents of cobalt and aggregates and surface roughness were regarded as the same as in the Example 1 (measurement was not specifically performed). The lubricating oil was prepared by adding glycerin dioleate (GDO) to poly α-olefin (PAO) in an amount of 1% by volume in terms of outer percentage, and thoroughly stirred to put in use. The conditions of the friction test other than those mentioned above were the same as in the Example 1. The friction coefficient was 0.013.

### (Example 10)

In Example 10, a film was formed by use of the arc-ion plating (AIP) method. A steel disk having the same standard as in the Example 1 was used as a substrate. Cobalt powder was added to carbon to be used as a vaporization source in advance. Cobalt is applied on the film together with carbon by discharge to add cobalt to the film. The bias voltage to be applied to the substrate was set at 80 V. The film-growth rate was obtained in a preliminary test performed in the same manner as in the Example 1 except that the same cobalt-containing target as used in this example was used as the vaporization source. The film-growth rate was 0.47 µm per hour. Based on the results, a film-forming process was performed for 2 hours in this example. After completion of the film-forming process, the surface of the sample was lightly rubbed and thereafter the surface roughness (Ra) was measured. As a result, Ra was 0.031. Besides these, the contents of cobalt and aggregates were measured in the same manner as in the Example 1. The cobalt content and aggregate content were 9 atom% and 24 area%, respectively. Compared to the magnetron sputtering method, the content of aggregates was slightly large compared to the cobalt content. The evaluation of friction properties was performed in engine oil 5W30SL in the same manner as in the Example 1. The friction coefficient was 0.025.

### (Comparative Example 1)

In the same manner as in the Example 1, the surface of the substrate similar to that of the Example 1 was coated with a hard carbon film by magnetron sputtering using a carbon target. The sputtering target was prepared by placing a fan-shaped metal cobalt plate having a radius of 80 mm and an apex angle of 7.5° on a disk-form carbon target of 80 mm in radius, The substrate bias-voltage was set at 100 V and the plasma excitation power was set at 200 W. As the film growth rate, the result in the preliminary test performed in the Example 6 was used as it was. A film-forming process was performed at 3 hours. After completion of the film-formingprocess, the surface roughness of the sample was measured. As a result, Ra was 0.019 µm. The film was analyzed in the same manner as in the Example 1, the content of cobalt was 15 atom% and the content of aggregates was 43 area%. The friction coefficient was 0.053.

### (Comparative Example 2)

The surface of the same substrate as used in the Example 1 was coated with a hard carbon film by magnetron sputtering using carbon as a target in the same manner as in the Example 1. The target of sputtering was prepared by placing a fan-shaped metal cobalt plate having a radius of 80 mm and an apex angle of 7.5° on a disk-form carbon target of 80 mm in radius. The substrate bias voltage was set at 40 V and the plasma excitation power was set at 600 W. The film-growth rate was obtained by a preliminary experiment performed in the same manner as in the Example 1 using no cobalt plate. The film growth rate was 0.67 µm per hour. Since the film-growth rate was fast, the time for a film-forming process was set at 1.5 hours. The surface roughness (Ra) of the sample was measured after completion of the film-forming process, and it was 0.034 µm. When the film was analyzed in the same manner as in the Example 1, the content of cobalt was 14 atom%, the content of aggregates was 55 area%, and the friction coefficient was 0. 069.

### (Comparative Example 3)

A film was formed by an arc ion plating (AIP) method in the same manner as in the Example 10. As a substrate, a steel disk having the same standard as in the Example 1 was used. Carbon was used as an evaporation source. Cobalt was doped into the resultant film by blending cobalt powder to the evaporation source in advance. In this case, the bias voltage of the substrate was raised to 120 V. The conditions other than the bias voltage were the same as those of the Example 10. A film-forming rate was obtained in a preliminary experiment performed in the same manner as in the Example 10. It was 0.59 µm per hour. Based on this, the time for a film-forming process was set at one hour and 40 minutes. After completion of the film-forming process, the surface of the sample was lightly rubbed and thereafter the surface roughness (Ra) was measured. As a result, Ra was 0.035. Besides this, the contents of cobalt and aggregates were determined in the same manner as in the Example 1. The cobalt content and aggregate content were 7 atom% and 42 area%, respectively. The content of aggregates increased compared to the Example 10. The friction properties were evaluated in engine oil 5W30SL in the same manner as in the Example 1. The friction coefficient was 0.047.

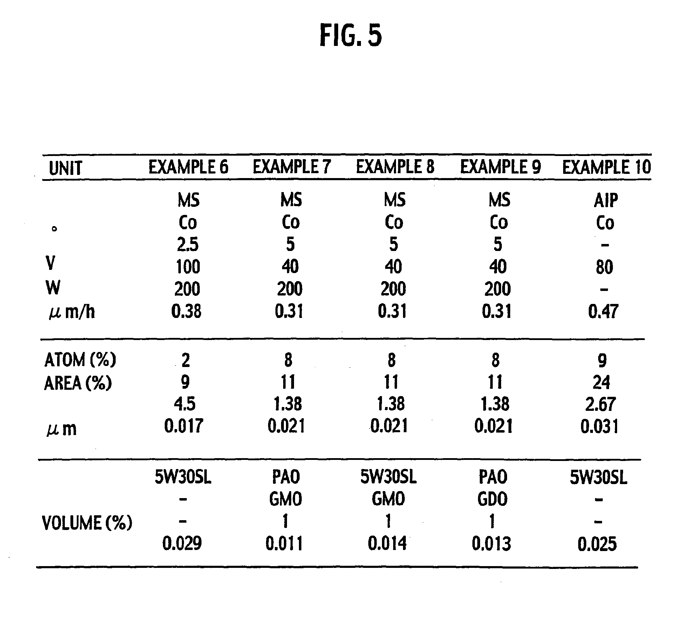

Figs. 4, 5 and 6 show the results of the Examples and Comparative Examples.

As is apparent from the results of Figs. 4, 5 and 6, in the hard carbon films of the Comparative Examples 1 to 3 containing cobalt and nickel and generating a larger amount of aggregates, the friction coefficients are high. In contrast, in Examples containing cobalt and nickel and successfully suppressing the amount of aggregates to a predetermined value or less, the friction coefficients are low. Among them, in the examples where the content of aggregate is controlled to 12 area% or less and a predetermined value or less based on the metal content of the film, a particularly low friction coefficient is obtained. Also, a low friction coefficient is obtained in the examples using a lubricant containing a compound having an intramolecular hydroxyl group as an additive, other than automobile engine oil. In this case, the larger the number of intramolecular hydroxyl groups, the larger the effect thereof (the lower the friction coefficient). As a particularly preferable example in the present invention, the Example 2 showing a low friction coefficient in engine oil can be mentioned.

### Second embodiment

When an AIP method is used in combination with a sputtering method in forming a hard carbon film, the resultant hard carbon film inevitably has a laminate structure in which deposition layers formed by the AIP method and deposition layers formed by the sputtering method are alternately stacked one on top of another, in consideration of the film formation principle. As a preferable embodiment, there is a method in which only carbon is supplied from a target of the AIP method, whereas a metal dopant (cobalt and/or nickel) is supplied from a sputtering target. The resultant hard carbon film has a laminate structure in which layers rich in dopant metal (hereinafter, "high dopant layer") formed by the sputtering method and layers poor in dopant (hereinafter, "low dopant layer") formed by the AIP method are alternately stacked one on top of the other. In this case, the concentration of the dopant metal depends on the depth from the surface. The term "content of cobalt and/or nickel" used in the claims refers to a gross average concentration of them in the high dopant layers and the low dopant layers. More specifically, a depth profile of concentration of them is obtained by X-ray photoelectron spectroscopy, etc., and averaged.

When a metal dopant is added by a sputtering method, the concentration of a metal dopant can be controlled, for example, by changing a power supplied to the sputtering target while a substantially constant amount of carbon is supplied from an AIP target; or by changing the area of the sputtering target occupied by a desired metal dopant. In the former method where power supply is changed, layers having a metal dopant in different contents can be formed by dynamically changing power supply during processing.

The present inventors have studied on a laminate structure in which high dopant layers and low dopant layers are alternately stacked one on top of the other, more specifically, as to what type of laminate structure effectively reduces friction, and the present invention has been achieved. They consider that friction can be reduced by a mechanism where dopant metals, cobalt and nickel, change electron distribution of neighboring carbon atoms and enhances absorption of base oil components and additive components of a lubricant on the surface of a substrate. They also assume that, the adsorption effect can be more largely exerted desirably by increasing the spatial frequency of the high dopant layer (rich in a metal dopant) in contact with the low dopant layer formed by the AIP method.

More specifically, what should be done is only reducing the thickness of each of the high dopant layer and low dopant layer. In other words, the laminate number of the high dopant layers and low dopant layers can increase within a predetermined thickness. According to the studies of the present inventors, it has been found that the friction coefficient reduction effect is large when the laminate number per 100 nm thick is 8 or more, preferably 14 or more, and more preferably 25 or more. Assuming that a pair of a single high dopant layer and a single low dopant layer stacked one on top of the other is regarded as a "single laminate", 10 laminates consists of 10 high dopant layers and 10 low dopant layers stacked one on top of another. The number of laminates per unit thickness can be increased (1) decreasing the growth rate of each layer, (2) increasing the rotation (revolution) speed of a sample in a furnace, and (3) using a plurality of targets that are to be attached to a slot of a vacuum apparatus. While it is better to have a larger number of laminates per unit thickness, in the case (1), time required for a single film formation step increases. Therefore, this case is unfavorable in view of cost. In the case (2), there is a limit in rotation speed depending on the capacity of the apparatus. The case (3) is a relativelypreferable; however, there are limitations in the number of targets simultaneously attached to a vacuum chamber and the capacity of power supply source for driving a target. Since there are limitations in either case, the number of laminates should be appropriately set in practice.

The Examples of the present embodiment are explained below with Comparative Examples.

### (Example 11)

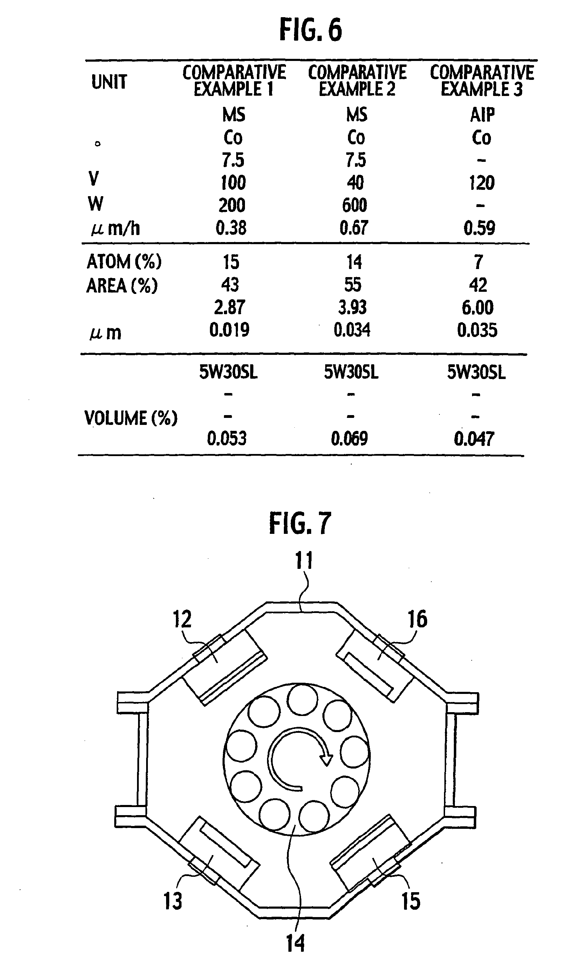

A disk-form substrate formed of cement steel (Japanese Industry Standard, SCM 415) and having 30 mm diameter and 3 mm thick was prepared. The surface of the substrate was treated with planishing so as to obtain a surface roughness Ra of 0.020 µm. The disk-form substrate of the same standard was commonly used in the following Examples and Comparative Examples. A hard carbon film was then formed on the disk-form substrate by the vacuum f ilm-forming apparatus shown in Fig. 7. The disk-form substrate was installed to a rotation stage 14 substantially in perpendicular. To the disk-form substrate, a bias voltage of 100 V was applied. The vacuum film-forming apparatus equipped with a sputtering target 12 and an AIP target 13. The slots 15 and 16 of the vacuum film-forming apparatus are provided as dummies, and they are not used for raw-material supply.

The AIP target 13 consists of graphite and inevitable impurities. The sputtering target 12 is formed of a carbon plate having a cobalt thin film attached thereon. Based on the results of a preliminary performed experiment, driving conditions for the AIP target were controlled such that a film-forming rate became 300 nm/hour. Similarly, driving conditions for the sputtering target were controlled such that a film-forming rate became 300 nm/hour. In the sputtering target, the area of the cobalt thin film attached onto the carbon plate was previously controlled such that the resultant film contained cobalt in a concentration of 15 atom%. The film-forming process was performed for 2 hours under the aforementioned conditions. The sample was rotated once per minute and autorotation was not performed. Totally 120 rotations were performed in the film-forming process.

After completion of the film-forming process, the sample was taken out. The sample was evaluated for three items: (1) friction coefficient; (2) Sectional state observed by transmission electron microscope (TEM); and (3) metal dopant concentration (measured by X-rayphotoelectron spectroscopy (XPS)). First, XPS was performed as follows: The sample was housed inameasurement apparatus. While the surface of the sample was sputtered by argon gas, the content of cobalt was analyzed every 2.5 nm to a depth of 100 nm. An average of the 40-point data was taken and used as the content of cobalt. If the number of measurement points is sufficiently large, the average value can represent an average content of cobalt in a laminate structure consisting of a low dopant layer (AIP) and a high dopant layer (sputtering). As a result of measurement, an average cobalt content was 7 atom%.

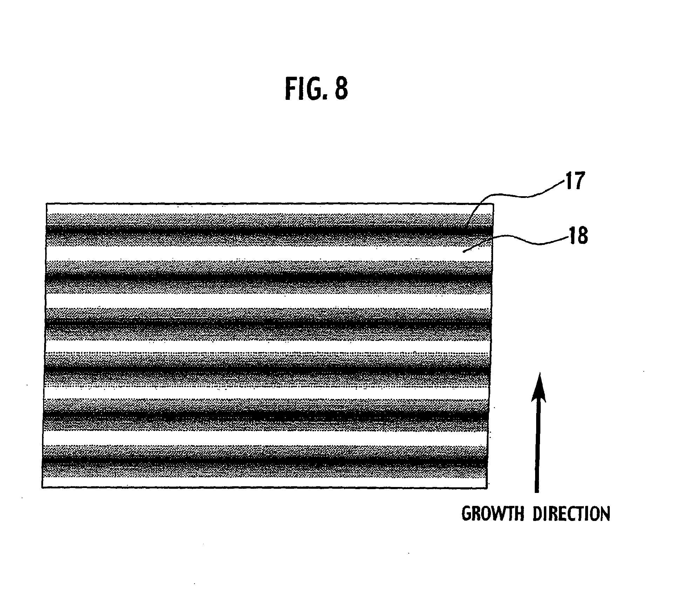

Subsequently, a section of the sample was observed by a TEM. The substrate of the sample was cut in perpendicular to the surface of the substrate by a focus ion beam (FIB) apparatus. The section thus obtained was observed by a TEM. The thickness of the section to be observed was set to be 100 nm. When the section was observed by a TEM, the cobalt-rich portion was seen as a dark region. As schematically shown in Fig. 8, a stripe pattern was observed in which the dark and light stripes correspond to the high dopant layer (sputtering) and the low dopant layer (AIP), respectively. Of course, the stripes are formed almost in parallel to the substrate. Based on the results of the TEM observation, the film thickness was 1140 nm. The repeat of the stripes was analyzed as below. Assuming that a pair of a dark stripe and a light stripe was a single laminate, the number of repeats laminates appearing in the stripe pattern were counted. As a result, 9 dark-and-light repeats laminates were observed from the surface to a depth of 100 nm.

Next, the sample was evaluated for friction properties by the ball-on-disk test. In the test, automobile engine oil 5W-30SL was used as a lubricant. While the sample was rotated in the engine oil, a ball formed of bearing steel (Japanese Industrial Standard SUJ2) and having a diameter of 6 mm was pressed against the sample and the torque applied to an arm holding the ball was measured. Based on the torque, a friction coefficient was calculated. The diameter of a sliding mark was 8 mm and the temperature of the engine oil was set at 80°C. A vertical load applied to the ball was 20N. Note that the ball was fixed so as not to roll by sliding. A sliding rate was set at 1.67 cm per second. The friction coefficient was calculated in consideration of adaptation of the material of the substrate immediately after the initiation of sliding. Therefore, a measurement value obtained 5 minutes after initiation of the test was regarded as the friction coefficient of the material. The friction coefficient of the hard carbon film of this embodiment was 0.028. The surface roughness (Ra) of the sample before measurement was 0.017 µm.

### (Example 12)

A hard carbon film was formed in the same manner as in the Example 11. In Example 12, a nickel plate was placed on the carbon plate of a sputtering target. The area of the nickel plate was controlled such that the content of nickel in the sputtering layer was 70 atom%. Only carbon was contained in the AIP target. Other film forming conditions and evaluation conditions were the same as in the Example 11. In the Example 12, an average content of nickel was 36 atom%, the number of laminates from the surface to 100 µm in depth was 9, the film thickness was 1050 nm, and the surface roughness (Ra) was 0.019 µm. The friction coefficient was 0.029.

### (Example 13)

A hard carbon film was formed in the same manner as in the Example 11. In Example 13, a cobalt plate was placed on the carbon plate of a sputtering target. The area of the cobalt plate was controlled such that the content of cobalt in the sputtering layer was 30 atom%. Only carbon was used in the AIP target. The rotation rate during the film-forming process was twice per minute. The film-forming process was performed for 2 hours. Other film forming conditions and evaluation conditions were the same as in the Example 11. In the Example 13, an average cobalt content was 12 atom%, the number of laminates from the surface to a depth of 100 nm was 16, the film thickness was 990 nm, and the surface roughness (Ra) was 0.020 µm. The friction coefficient was 0.025.

### (Example 14)

A hard carbon film was formed in the same manner as in the Example 11. In Example 14, a cobalt plate was placed on the carbon plate of a sputtering target. The area of the cobalt plate was controlled such that the content of cobalt in the sputtering layer was 30 atom%. Only carbon was used in the AIP target. The rotation rate during the film-forming process was three times per minute. The film-forming process was performed for 2 hours. Other film forming conditions and evaluation conditions were the same as in the Example 11. In the Example 14, an average cobalt content was 14 atom%, the number of laminates from the surface to a depth of 100nmwas26, the film thickness was 1090 nm, and the surface roughness (Ra) was 0.018 µm. The friction coefficient was 0.020.

### (Example 15)

A hard carbon film was formed in the same manner as in the Example 11. In Example 15, a cobalt plate was placed on the carbon plate of a sputtering target. The area of the cobalt plate was controlled such that the content of cobalt in the sputtering layer was 30 atom%. Note that the current to be supplied to the AIP target and the power to be supplied to the sputtering target were reduced such that the film-forming rates by both deposition methods were 100 nm/hour. The rotation rate during the film-forming process was three per minute, and the film-forming process was performed for 2 hours. Other film forming conditions and evaluation conditions were the same as in the Example 11. In the Example 15, an average cobalt content was 15 atom%, the number of laminates from the surface to a depth of 100 nm was 24, the film thickness was 1160 nm, and the surface roughness (Ra) was 0.018 µm. The friction coefficient was 0.021.

### (Example 16)

A hard carbon film was formed in the same manner as in the Example 11. In Example 16, a cobalt plate was placed on the carbon plate of a sputtering target. The area of the cobalt plate was controlled such that the content of cobalt in the sputtering layer was 20 atom%. Note that the current to be supplied to the AIP target and the power to be supplied to the sputtering target were changed from those of the Example 11 such that the AIP film-forming rate and sputtering film-forming rate were 200 nm/hour and 400 nm/hour, respectively. The rotation rate during the film-forming process was three per minute. The film-forming process was performed for 2 hours. Other film forming conditions and evaluation conditions were the same as in the Example 11. In the Example 16, an average cobalt content was 8 atom%, the number of laminates from the surface to a depth of 100 nm, the film thickness was 1180 nm, and the surface roughness (Ra) was 0.020 µm. The friction coefficient was 0.027.

### (Comparative Example 4)

A hard carbon film was formed in the same manner as in the Example 11. In Comparative Example 4, a cobalt plate was placed on the carbon plate of a sputtering target. The area of the cobalt plate was controlled such that the content of cobalt in the sputtering layer was 30 atom%. Note that the current to be supplied to the AIP target and the power to be supplied to the sputtering target were controlled such that both film-forming rates were 500 nm/hour. The rotation rate during the film-formingprocesswas once per minute. The film-forming process was performed for one hour. Other film forming conditions and evaluation conditions were the same as in the Example 11. In the Comparative Example 4, an average cobalt content was 14 atom%, the number of laminates from the surface to a depth of 100 nm was 6, the film thickness was 1030 nm, and the surface roughness (Ra) was 0.020 µm. The friction coefficient was 0.035. The friction coefficient was high, presumably because the number of layers was insufficient.

### (Comparative Example 5)

A hard carbon film was formed in the same manner as in the Example 11. In Comparative Example 5, a nickel plate was placed on the carbon plate of a sputtering target. The area of the nickel plate was controlled such that the content of nickel in the sputtering layer was 20 atom%. Note that the current to be supplied to the AIP target and the power to be supplied to the sputtering target were controlled such that both film-forming rates were 500 nm/hour. The rotation rate during the film- forming process was once per minute. The film-forming process was performed for one hour. Other film forming conditions and evaluation conditions were the same as in the Example 11. In the Comparative Example 5, an average cobalt content was 9 atom%, the number of laminates from the surface to a depth of 100 nm was 7, the film thickness was 960 nm, and the surface roughness (Ra) was 0.020 µm. The friction coefficient was 0.037. The friction coefficient was high, presumably because the number of layers was insufficient.

### (Comparative Example 6)

A hard carbon film was formed in the same manner as in the Example 11. In Comparative Example 6, only a sputtering target was used but the AIP target was not used. A cobalt plate was placed on the carbon plate of the sputtering target. The area of the cobalt plate was controlled such that the content of cobalt in the sputtering layer was 5 atom%. A film-forming rate was controlled to be 300 nm/hour. The rotation rate during the film-forming process was three per minute. The film-forming process was performed for 3 hours. Other film forming conditions and evaluation conditions were the same as in the Example 11. In the Comparative Example 6, an average cobalt content was 4 atom%. No stripe was observed under TEM observation. Therefore, the number of laminates from the surface to a depth of 100 nm was regarded as 0. The film thickness was 920 nm and the surface roughness (Ra) was 0.016 µm. The friction coefficient was 0.036. The friction coefficient was high, presumably because there was no laminate structure.

### (Comparative Example 7)

A hard carbon film was formed in the same manner as in the Example 11. In Comparative Example 7, only the AIP target was used but a sputtering target was not used. Since the AIP target consists of only carbon, no metal was substantially doped into the film in this Example. The film-forming rate was controlled to be 300 nm/hour. The rotation rate during the film-forming process was three per minute. The film-forming process was performed for 3 hours. Other film forming conditions and evaluation conditions were the same as in the Example 11. In the Comparative Example 7, the average contents of cobalt and nickel were noise levels. No stripe was observed under TEM observation. Therefore, the number of laminates from the surface to a depth of 100 nm was regarded as 0. The film thickness was 940 nm and the surface roughness (Ra) was 0.025 µm. The friction coefficient was 0.044. The friction coefficient was high, presumably because there was no laminate structure.

As is apparent from the results, a hard carbon film doped with cobalt and nickel and having a low friction coefficient can be obtained by alternately stacking a high dopant layer (rich in cobalt/nickel) and a low dopant layer one on top of another such that the number of laminates falls within a predetermined value per unit thickness. The Example 14 exhibiting a low friction coefficient can be mentioned as a preferable example. The film of the Example 15 shows a low friction coefficient but unfavorable in view of cost since it is formed at a low film-forming rate. The high dopant layer and the low dopant layer with nickel and/or cobalt are not necessary to have the same thickness and can have a different thickness as is in the Example 16.

Description has been made of the embodiments to which the invention created by the inventors of the present invention is applied However, the present invention is not limited to the descriptions and the drawings, which form a part of the disclosure of the present invention according to these embodiments. Specifically, all of other embodiments, examples, operational techniques and the like, which are made by those skilled in the art based on these embodiments, are naturally incorporated in the scope of the present invention. The above is additionally described at the end of this specification.

The entire content of Japanese Patent Application No. TOKUGAN 2006-119116 with a filing date of April 24, 2006 and Japanese Patent Application No. TOKUGAN 2006-119098 with a filing date of April 24, 2006 is hereby incorporated by reference.

## Claims

1. A hard carbon film containing amorphous carbon as a main component and cobalt and/or nickel in a total amount of more than 1.4 to less than 39 atom% as a sub component, and having a laminate structure formed by stacking layers having a relatively high cobalt/nickel content and layers having a relatively low cobalt/nickel content one on top of another, wherein
- the number of laminates in a thickness direction, each consisting of a layer having a relatively high cobalt/nickel content and a layer having a relatively low cobalt/nickel content, is 8 or more per 100 nm.

2. The hard carbon film according to claim 1, wherein
- the number of laminates in a thickness direction, each consisting of a layer having a relatively high cobalt/nickel content and a layer having a relatively low cobalt/nickel content, is 14 or more per 100 nm.

3. The hard carbon film according to claims 1 or 2, wherein
- the number of laminates in a thickness direction, each consisting of a layer having a relatively high cobalt/nickel content and a layer having a relatively low cobalt/nickel content, is 25 or more per 100 nm.

4. The hard carbon film according to any one of claims 1 to 3, wherein
- the layer having a relatively low cobalt/nickel content is formed by use of the arc-ion plating method.

5. Use of a hard carbon film according to any of claims 1 to 4 in a lubricant.

6. A hard carbon film sliding member comprising the hard carbon film according to any one of claims 1 to 4.
